# EUROPEAN PATENT APPLICATION

(11) **EP 4 372 797 A1**
(43) Date of publication of application: **22.05.2024**
(21) Application number: 23210428.1
(22) Date of filing: 16.11.2023
(51) Int. Cl.: H01L 21/8234, H01L 23/528, H01L 27/088, H10B 10/00, H01L 21/8238, H01L 27/092

(54) **INTEGRATED CIRCUIT INCLUDING CELL ARRAY AND BACKSIDE POWER RAIL**

(30) Priority: 17.11.2022 KR 20220154879; 09.01.2023 KR 20230003035
(71) Applicant: Samsung Electronics Co., Ltd., Suwon-si, Gyeonggi-do 16677 (KR)
(72) Inventor: KIM, Taehyung, 16677 Suwon-si (KR)
(74) Representative: Marks & Clerk LLP

(57) **Abstract**

An integrated circuit includes a cell array comprising a plurality of cells, each of the plurality of cells including at least one transistor, a power rail (PL1, PL2) in a power rail layer under the cell array, the power rail being configured to provide power to the cell array, and a plurality of contacts (BC1, BC2) between the cell array and the power rail. Each of the plurality of contacts extends downward from a source of a transistor of a corresponding one of the cells to the power rail.

## Description

### BACKGROUND

The present disclosure relates to an integrated circuit (IC), and more particularly, to an IC including a cell array and a backside power rail.

Due to the demand for high integration density and the development of semiconductor processes, the width, spacing, and/or height between wirings included in ICs may be reduced, and thus, the influence of parasitic elements of the wirings may increase. In addition, to reduce power consumption and increase the operation speed, a power supply voltage of the ICs may be reduced, and thus, the influence of the parasitic elements of the wirings upon the ICs may further increase. Despite the parasitic elements, an IC including a cell array including cells with the same structure may be required to stably provide high integration density and performance according to the requirements of various applications.

### SUMMARY

It is an aspect to provide an integrated circuit (IC) including a cell array configured to receive power through a backside power rail.

According to an aspect of one or more embodiments, there is provided an integrated circuit comprising a cell array comprising a plurality of cells, each of the plurality of cells including at least one transistor; a power rail in a power rail layer under the cell array, the power rail being configured to provide power to the cell array; and a plurality of contacts between the cell array and the power rail, wherein each of the plurality of contacts extends downward from a source of a transistor of a corresponding one of the plurality of cells to the power rail.

According to another aspect of one or more embodiments, there is provided an integrated circuit comprising a cell array comprising a plurality of cells, each of the plurality of cells including at least one transistor; a power rail in a power rail layer under the cell array, the power rail being configured to provide power to the cell array; and a plurality of contacts between the cell array and the power rail, wherein each of the plurality of contacts has a top surface connected to a source of a transistor of a corresponding one of the plurality of cells and a bottom surface connected to the power rail.

According to yet another aspect of one or more embodiments, there is provided an integrated circuit comprising a cell array comprising a plurality of cells, each cell comprising two inverters that are cross-coupled to each other; a power rail in a power rail layer under the cell array; and a plurality of contacts between the cell array and the power rail, wherein each of the plurality of contacts extends downward from a source of a transistor of a corresponding one of the two inverters to the power rail.

At least some of the above and other features of the invention are set out in the claims.

### BRIEF DESCRIPTION OF THE DRAWINGS

Various embodiments will be more clearly understood from the following detailed description taken in conjunction with the accompanying drawings, in which:
FIGS. 1A and 1B are layout diagrams of integrated circuits (IC), according to some embodiments;
FIGS. 2A to 2D are diagrams of examples of a device, according to some embodiments;
FIG. 3 is a block diagram of an IC, according to some embodiments;
FIG. 4 is a circuit diagram of a memory cell, according to some embodiments;
FIGS. 5A and 5B are plan views of a layout illustrating an IC, according to some embodiments;
FIGS. 6A to 6C are plan views of a layout illustrating an IC, according to some embodiments;
FIGS. 7A to 7D are plan views of examples of a backside power rail, according to some embodiments;
FIG. 8A is a diagram of an example of a layout of an IC, and FIG. 8B is a diagram of an example of a layout of an IC, according to some embodiments; and
FIG. 9 is a block diagram of a System-on-Chip (SoC), according to some embodiments.

### DETAILED DESCRIPTION

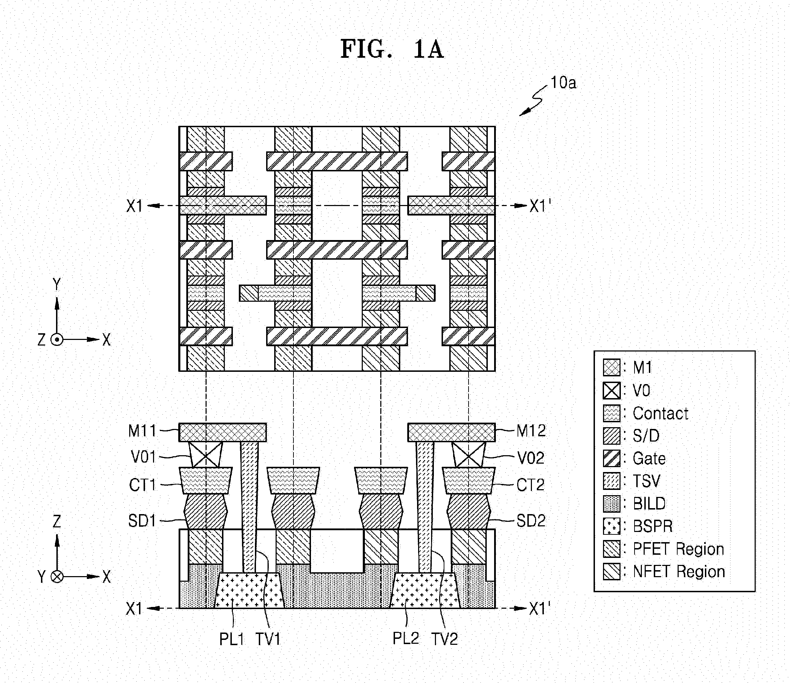

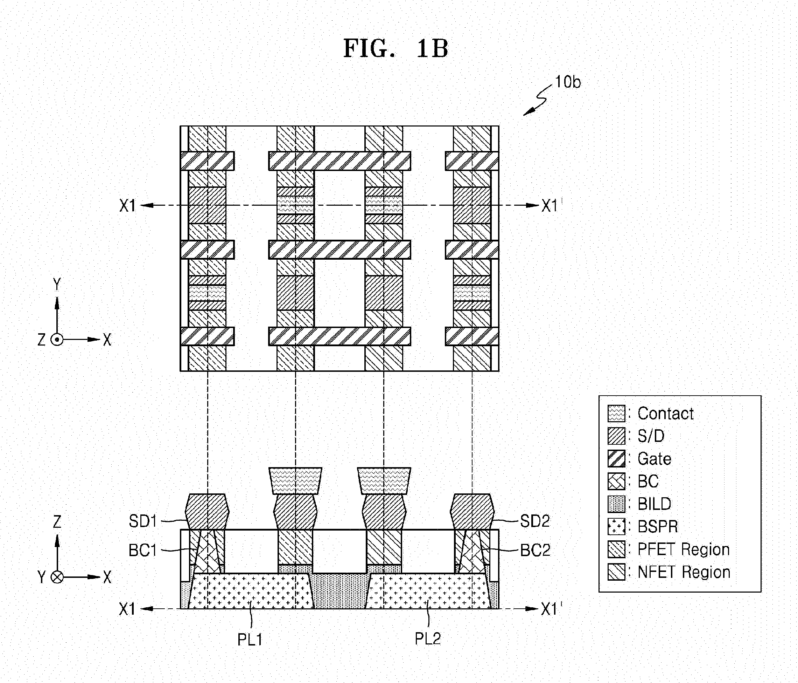

FIGS. 1A and 1B are layout diagrams of integrated circuits (IC), according to some embodiments. FIGS. 1A and 1B show both of a plan view of the IC and a cross-sectional view of the IC, which is taken along line X1-X1'.

As used herein, an X-axis direction and a Y-axis direction may be respectively referred to as a first horizontal direction and a second horizontal direction, and a Z-axis direction may be referred to as a vertical direction or a third direction. A plane formed by an X-axis and a Y-axis may be referred to as a horizontal plane. A component located in a +Z direction relative to another component may be referred to being above the other component, and a component located in a -Z direction relative to another component may be referred to being below the other component. An area of a component may refer to a size occupied by the component on a plane parallel to the horizontal plane, and a width of a component may refer to a length of the component in a direction orthogonal to a direction in which the component extends. A surface exposed in the +Z direction may be referred to as a top surface, a surface exposed in the -Z direction may be referred to as a bottom surface, and a surface exposed in a ±X direction or a ±Y direction may be referred to as a side surface. In the drawings, only some layers may be illustrated for brevity, a via configured to connect a top pattern to a bottom pattern may be illustrated for clarity although the via is under the top pattern. In addition, a pattern including a conductive material (e.g., a pattern of a wiring layer) may be referred to as a conductive pattern or may be simply referred to as a pattern.

The IC may include a power line configured to provide a positive supply voltage or a negative supply voltage to a device (e.g., a transistor). For example, as shown in FIG. 1A, a first power line PL1 may provide the positive supply voltage to a p-channel field effect transistor (PFET) formed in a PFET region, and extend in the Y-axis direction, and a second power line PL2 may provide the negative supply voltage to an n-channel FET (NFET) formed in an NFET region, and extend in the Y-axis direction. The power line may include a conductive material. Power lines may be referred to collectively as a power rail. As used herein, a layer at which the power line is formed may be referred to as a power line layer or a power rail layer.

In some embodiments, the IC may include a power line extending under the transistor, and the transistor may be formed over the power line layer. For example, as shown in FIGS. 1A and 1B, the IC may include a backside power rail (BSPR). Differently from that shown in FIGS. 1A and 1B, in a configuration in which a power line extends over the transistor, the power line may consume routing space for signals, and thus, routing congestion may occur. On the other hand, the routing space for the signals may increase due to the BSPR, and thus, the IC may have a reduced area and/or an efficient structure. As used herein, the BSPR may be simply referred to as a power rail.

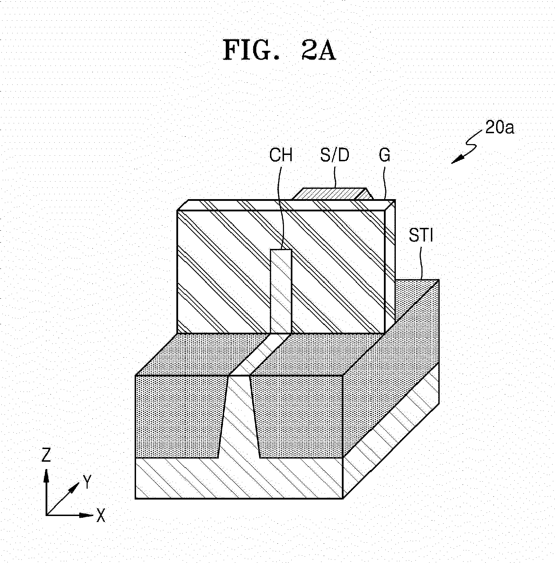

Referring to FIG. 1A, an IC 10a may include PFET regions and NFET regions, which extend in the Y-axis direction, and gates extending in the X-axis direction. Source/drains may be formed on both sides of the gate, and a contact may be formed on the source/drain. A channel may be formed between the source/drains under the gate. Examples of the channel will be described below with reference to FIGS. 2A to 2D. The first power line PL1 may extend in the Y-axis direction under the PFET regions, and the second power line PL2 may extend in the Y-axis direction under the NFET regions. In some embodiments, a positive supply voltage may be applied to the first power line PL1, and a negative supply voltage may be applied to the second power line PL2. A backside interlayer dielectric (BILD) may be between the first power line PL1 and the second power line PL2.

The IC 10a may include a via connected to the power line and the pattern of the wiring layer. For example, as shown in FIG. 1A, a first through silicon via (TSV) TV1 may have a bottom surface connected to the first power line PL1 and a top surface connected to a first pattern M11 of an M1 layer. A second TSV TV2 may have a bottom surface connected to the second power line PL2 and a top surface connected to a second pattern M12 of the M1 layer.

The first pattern M11 of the M1 layer may be connected to a first source/drain SD1 through a first via V01 and a first contact CT1. When the positive supply voltage is applied to the first power line PL1, the first source/drain SD1 may be a source of the PFET. The positive supply voltage may be provided from the first power line PL1 through the first TSV TV1, the first pattern M11, the first via V01, and the first contact CT1 to the first source/drain SD1. The second pattern M12 of the M1 layer may be connected to a second source/drain SD2 through a second via V02 and a second contact CT2. When the negative supply voltage is applied to the second power line PL2, the second source/drain SD2 may be a source of the NFET. The negative supply voltage may be provided from the second power line PL2 through the second TSV TV2, the second pattern M12, the second via V02, and the second contact CT2 to the second source/drain SD2.

Referring to FIG. 1B, an IC 10b may include PFET regions and NFET regions, which extend in the Y-axis direction, and gates extending in the X-axis direction. Source/drains may be formed on both sides of the gate, and a contact may be formed on the source/drain. A channel may be formed between the source/drains under the gate. Examples of the channel will be described below with reference to FIGS. 2A to 2D. The first power line PL1 may extend in the Y-axis direction under the PFET regions, and the second power line PL2 may extend in the Y-axis direction under the NFET regions. In some embodiments, the positive supply voltage may be applied to the first power line PL1, and the negative supply voltage may be applied to the second power line PL2. A BILD may be between the first power line PL1 and the second power line PL2.

The IC 10b may include a contact, which is connected to the power line and the source/drain. For example, as shown in FIG. 1B, a first backside contact (BC) BC1 may have a bottom surface connected to the first power line PL1 and a top surface connected to the first source/drain SD1. A second BC BC2 may have a bottom surface connected to the second power line PL2 and a top surface connected to the second source/drain SD2. As used herein, like the first BC BC1 and the second BC BC2, a contact configured to connect the source/drain to a backside power line may be referred to as a direct backside contact (DBC).

When the positive supply voltage is applied to the first power line PL1, the first source/drain SD1 may be a source of the PFET, and the positive supply voltage may be provided from the first power line PL1 through the first BC BC1 to the first source/drain SD1. The positive supply voltage may be provided to the first source/drain SD1 through a shorter path than in the IC 10a of FIG. 1A, and thus, a low voltage drop (or IR drop) may occur. When the negative supply voltage is applied to the second power line PL2, the second source/drain SD2 may be a source of the NFET, and the negative supply voltage may be provided from the second power line PL2 through the second BC BC2 to the second source/drain SD2. The negative supply voltage may be provided to the second source/drain SD2 through a shorter path than in the IC 10a of FIG. 1A, and thus, a low IR drop may occur.

In some embodiments, a BSPR may be used to supply power to a cell array in which a plurality of cells having the same structure are arranged. For example, the cell array may be a pixel array of a display panel, a pixel array of an image sensor, and/or a memory cell array of a memory device. Accordingly, power may be supplied to the cell of the cell array through a shortened path, and the IC may have high operation reliability. In some embodiments, patterns for power routing may be removed from a wiring layer (i.e. the patterns for power routing are not present in the wiring layer). As a result, a parasitic component of a signal path may be reduced, and thus, the IC may have a high operation speed. Furthermore, due to the routing space ensured by the BSPR, signals may be efficiently routed, and the IC may have a reduced area and/or an efficient structure. Although a memory cell array is described below as an example of the cell array, it is noted that embodiments may be applied to other cell arrays.

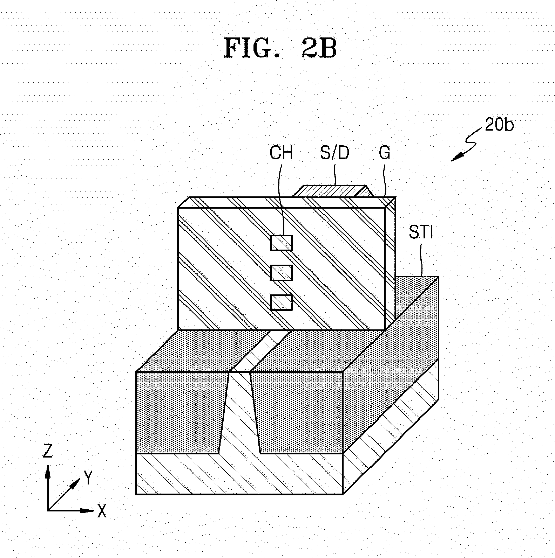

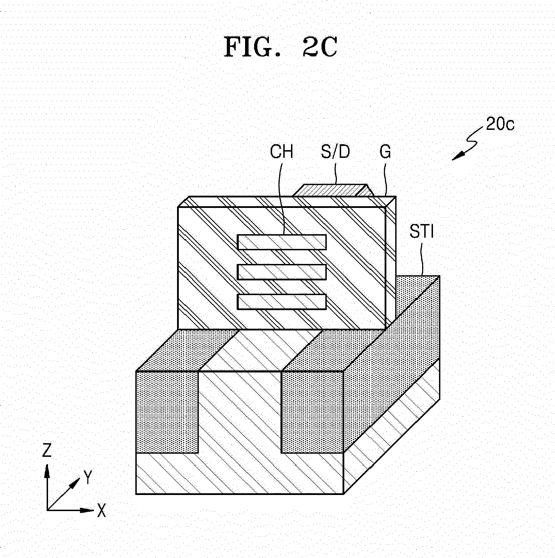

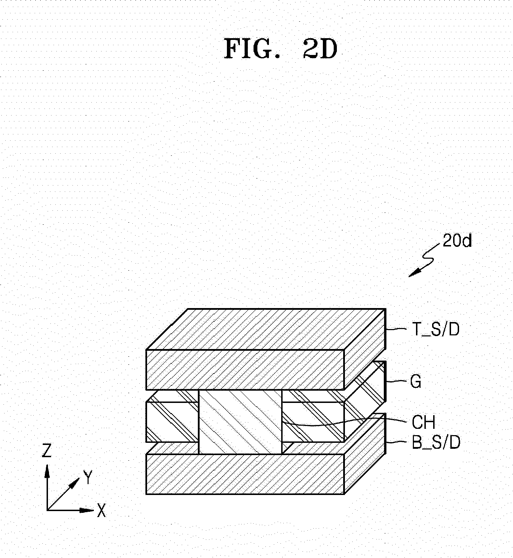

FIGS. 2A to 2D are diagrams of examples of a device according to some embodiments. For example, FIG. 2A illustrates a fin field-effect transistor (FiNFET) 20a, FIG. 2B illustrates a gate-all-around field effect transistor (GAAFET) 20b, FIG. 2C illustrates a multi-bridge channel field effect transistor (MBCFET) 20c, and FIG. 2D illustrates a vertical field-effect transistor (VFET) 20d. For brevity and ease of explanation, FIGS. 2A to 2C each shows a state in which one of two source/drain regions is removed, and FIG. 2D shows a cross-section of the VFET 20d, which is taken along a plane that is parallel to a plane formed by a X-axis and a Z-axis and passes through a channel CH of the VFET 20d.

Referring to FIG. 2A, the FiNFET 20a may be formed by a fin-type active pattern, which extends in an Y-axis direction between shallow trench isolations (STIs), and a gate G which extend in a X-axis direction. Source/drain regions S/D may be formed on both sides of the gate G, and thus, a source and a drain may be apart from each other in an Y-axis direction with the gate G therebetween. An insulating film may be formed between the channel CH and the gate G. In some embodiments, the FiNFET 20a may be formed by a plurality of active patterns, which are apart from each other in the X-axis direction, and a gate G.

Referring to FIG. 2B, the GAAFET20b may be formed by active patterns (e.g., nanowires), which are apart from each other in a Z-axis direction and extend in an Y-axis direction, and a gate G that extends in a X-axis direction. Source/drain regions S/D may be formed on both sides of the gate G, and thus, a source and a drain may be apart from each other in the Y-axis direction with the gate G therebetween. An insulating film may be formed between the channel CH and the gate G. In some embodiments, the channel CH may include a plurality of nanowires. However, it is noted that the number of nanowires in the GAAFET 20b is not limited to the three illustrated in FIG. 2B.

Referring to FIG. 2C, the MBCFET 20c may be formed by active patterns (e.g., nanosheets), which are apart from each other in a Z-axis direction and extend in an Y-axis direction, and a gate G, which extends in a X-axis direction. Source/drain regions S/D may be formed on both sides of the gate G, and thus, a source and a drain may be apart from each other in the Y-axis direction. An insulating film may be formed between the channel CH and the gate G. In some embodiments, the channel may include a plurality of nanosheets. However, it is noted that the number of nanosheets in the MBCFET 20c is not limited to the three illustrated in FIG. 2C.

Referring to FIG. 2D, the VFET 20d may include a top source/drain region T_SID and a bottom source/drain region B_S/D, which are apart from each other in a Z-axis direction with the channel CH therebetween. The VFET 20d may include the gate G between the top source/drain region T_S/D and the bottom source/drain region B_S/D, which surrounds the channel CH between the top source/drain region T_S/D and the bottom source/drain region B_S/D. An insulating film may be formed between the channel CH and the gate G.

Although an IC including the FiNFET 20a or the MBCFET 20c is mainly described below, it is noted that elements included in the IC are not limited to the examples shown in FIGS. 2A to 2D. For example, in some embodiments, the IC may include a ForkFET having a structure in which an N-type transistor and a P-type transistor are relatively closely formed to each other by separating nanosheets for the P-type transistor from nanosheets for the N-type transistor by dielectric walls. In some embodiments, the IC may include not only a FET, such as a complementary FET (CFET), a negative capacitance FET (NCFET), and a carbon nanotube (CNT) FET, but also a bipolar junction transistor.

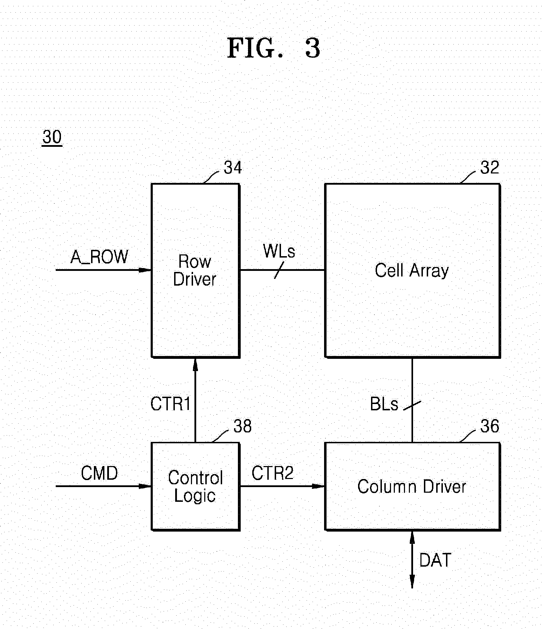

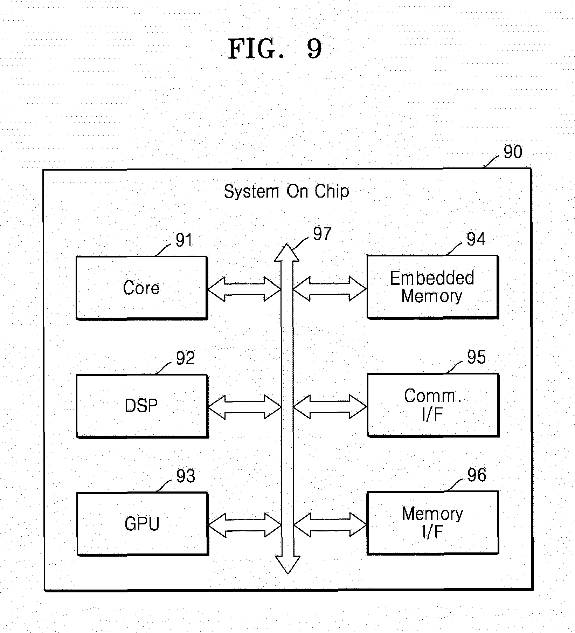

FIG. 3 is a block diagram of an IC according to some embodiments. For example, the block diagram of FIG. 3 illustrates a memory device 30 included in the IC. In some embodiments, the memory device 30 may store data based on a command and an address provided from the outside of the IC, and the memory device 30 may be a standalone memory device. In some embodiments, as described below with reference to FIG. 9, the IC may further include other components configured to write data to the memory device 30 or read data from the memory device 30, and the memory device 30 may be an embedded memory device. As shown in FIG. 3, the memory device 30 may include a cell array 32, a row driver 34, a column driver 36, and a control logic 38. Although not illustrated in FIG. 3, in some embodiments, the memory device 30 may further include an address buffer, a data buffer, a data input/output (I/O) circuit, and an internal voltage generator.

The memory device 30 may receive a command CMD, an address, and data DAT. For example, the memory device 30 may receive a command CMD indicating a write operation, an address, and data DAT, and store the received data DAT in a region of the cell array 32, which corresponds to the address. The memory device 30 may receive a command CMD indicating a read operation and an address, and output data stored in a region of the cell array 32, which corresponds to the address, to the outside.

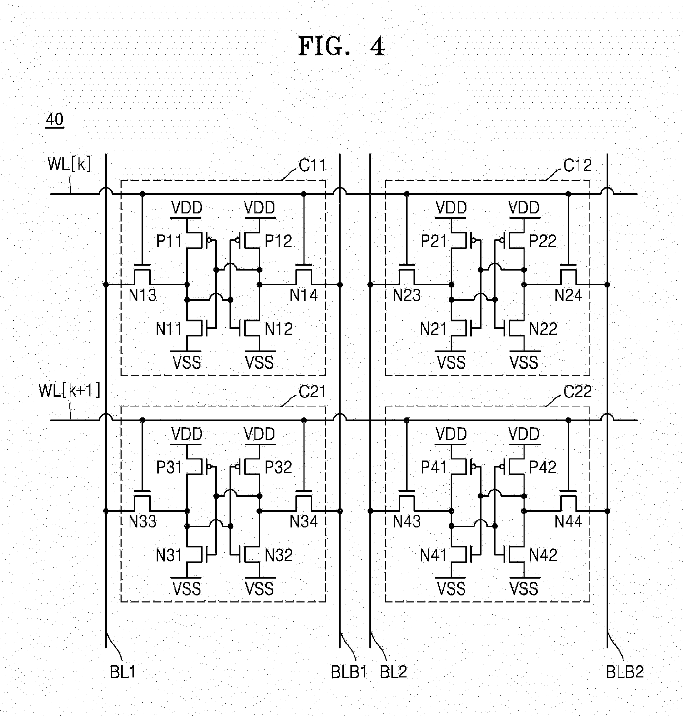

The cell array 32 may include a plurality of memory cells, each of which is accessed by a word line and a bit line. In some embodiments, the memory cells included in the cell array 32 may be volatile memory cells, such as static random access memory (SRAM) cells and dynamic RAM (DRAM) cells. In some embodiments, the memory cells included in the cell array 32 may be non-volatile memory cells, such as flash memory cells and resistive RAM (RRAM) cells. Although embodiments are mainly described with reference to an SRAM cell as described below with reference to FIG. 4, it is noted that the embodiments are not limited thereto. As used herein, a memory cell may be simply referred to as a cell.

The row driver 34 may be connected to the cell array 32 through a plurality of word lines WLs. The row driver 34 may enable one of the plurality of word lines WLs, based on a row address A_ROW. Accordingly, from among the memory cells included in the cell array 32, memory cells connected to an activated word line (i.e., memory cells in a row corresponding to the activated word line) may be selected. By the column driver 36 to be described below, the data DAT may be written to the selected memory cells during the write operation, while the data DAT may be read from the selected memory cells during the read operation.

The column driver 36 may be connected to the cell array 32 through a plurality of bit lines BLs. During the read operation, the column driver 36 may detect current and/or a voltage, which is received through the plurality of bit lines BLs, identify values stored in the selected memory cells connected to the activated word line, and output the data DAT based on identified values. During the write operation, the column driver 36 may apply current and/or a voltage to the plurality of bit lines BLs, based on the data DAT, and write values to the selected memory cells connected to the activated word line.

The control logic 38 may receive the command CMD and generate a first control signal CTR1 and a second control signal CTR2. For example, the control logic 38 may identify a read command by decoding the command CMD, and generate the first control signal CTR1 and the second control signal CTR2 to read the data DAT from the cell array 32. The control logic 38 may identify a write command by decoding the command CMD, and generate the first control signal CTR1 and the second control signal CTR2 to write the data DAT to the cell array 32. In some embodiments, the row driver 34 may activate or deactivate the word line at a point in time, which is determined based on the first control signal CTR1. In some embodiments, at a point in time, which is determined based on the second control signal CTR2, the column driver 36 may sense current and/or a voltage from the plurality of bit lines BLs or apply the current and/or the voltage to the plurality of bit lines BLs.

In some embodiments, the memory device 30 may include a BSPR under the cell array 32, and the memory cells included in the cell array 32 may receive power from the BSPR. Accordingly, power may be supplied to the memory cells of the cell array 32 through a shortened path, and the memory device 30 may have high operation reliability. In some embodiments, patterns for power routing may be removed from a wiring layer (i.e. the patterns for power routing are not present in the wiring layer). As a result, a parasitic component of a signal path may be reduced, and thus, the memory device 30 may have a high operation speed. Due to routing resources ensured by the BSPR, signals may be efficiently routed, and the memory device 30 may have a reduced area and/or an efficient structure.

FIG. 4 is a circuit diagram of memory cells according to some embodiments. For example, the circuit diagram of FIG. 4 illustrates an equivalent circuit 40 corresponding to four memory cells C11, C12, C21, and C22, which are adjacent to each other in the cell array 32 of FIG. 3. As shown in FIG. 4, each of the memory cells C11, C12, C21, and C22 may have the same structure.

Referring to FIG. 4, the memory cell C11 and the memory cell C12, which are in the same row, may be connected in common to a word line WL[k], and the memory cell C21 and the memory cell C22, which are in the same row, may be connected in common to a word line WL[k+1] (k is an integer greater than 0). The memory cell C11 and the memory cell C21, which are in the same column, may be connected to a first bit line BL1 and a first complementary bit line BLB1, and the memory cell C12 and the memory cell C22, which are in the same column, may be connected to a second bit line BL2 and a second complementary bit line BLB2.

Referring to FIG. 4, the memory cell C11 may include a first PFET P11, a second PFET P12, and a first NFET N11, a second NFET N12, a third NFET N13, and a fourth NFET N14 and be referred to as a six-transistors (6T) SRAM cell. The memory cell C11 may include a pair of inverters, which are cross-coupled between a node to which a positive supply voltage VDD is applied and a node to which a negative supply voltage (or ground potential) VSS is applied. In some embodiments, the memory cell C11 may include two inverters, which are cross-coupled between the node to which the positive supply voltage VDD is applied and the node to which the negative supply voltage (or ground potential) VSS is applied. For example, from among the pair of cross-coupled inverters, a first inverter may include the first PFET P11 and the first NFET N11, and a second inverter may include the second PFET P12 and the second NFET N12. The third NFET N13 and the fourth NFET N14 may be referred to as pass transistors configured to respectively connect the first inverter and the second inverter to the first bit line BL1 and the first complementary bit line BLB1 by a word line WL[k] that is activated (e.g., having a high-level voltage).

The memory cell C12 may include a first PFET P21, a second PFET P22, and a first NFET N21, a second NFET N22, a third NFET N23, and a fourth NFET N24 and be referred to as a 6T SRAM cell. The memory cell C21 may include a pair of inverters, which are cross-coupled between a node to which a positive supply voltage VDD is applied and a node to which a negative supply voltage (or ground potential) VSS is applied. In some embodiments, the memory cell C21 may include two inverters, which are cross-coupled between the node to which the positive supply voltage VDD is applied and the node to which the negative supply voltage (or ground potential) VSS is applied. For example, from among the pair of cross-coupled inverters, a first inverter may include the first PFET P21 and the first NFET N21, and a second inverter may include the second PFET P22 and the second NFET N22. The third NFET N23 and the fourth NFET N24 may be referred to as pass transistors configured to respectively connect the first inverter and the second inverter to the second bit line BL2 and the second complementary bit line BLB2 by a word line WL[k] that is activated (e.g., having a high-level voltage).

The memory cell C21 may include a first PFET P31, a second PFET P32, and a first NFET N31, a second NFET N32, a third NFET N33, and a fourth NFET N34 and be referred to as a 6T SRAM cell. The memory cell C21 may include a pair of inverters, which are cross-coupled between a node to which a positive supply voltage VDD is applied and a node to which a negative supply voltage (or ground potential) VSS is applied. In some embodiments, the memory cell C21 may include two inverters, which are cross-coupled between the node to which the positive supply voltage VDD is applied and the node to which the negative supply voltage (or ground potential) VSS is applied. For example, from among the pair of cross-coupled inverters, a first inverter may include the first PFET P31 and the first NFET N31, and a second inverter may include the second PFET P32 and the second NFET N32. The third NFET N33 and the fourth NFET N34 may be referred to as pass transistors configured to respectively connect the first inverter and the second inverter to the first bit line BL1 and the first complementary bit line BLB1 by a word line WL[k+1] that is activated (e.g., having a high-level voltage).

The memory cell C22 may include a first PFET P41, a second PFET P42, and a first NFET N41, a second NFET N42, a third NFET N43, and a fourth NFET N44 and be referred to as a 6T SRAM cell. The memory cell C41 may include a pair of inverters, which are cross-coupled between a node to which a positive supply voltage VDD is applied and a node to which a negative supply voltage (or ground potential) VSS is applied. In some embodiments, the memory cell C41 may include two inverters, which are cross-coupled between the node to which the positive supply voltage VDD is applied and the node to which the negative supply voltage (or ground potential) VSS is applied. For example, from among the pair of cross-coupled inverters, a first inverter may include the first PFET P41 and the first NFET N41, and a second inverter may include the second PFET P42 and the second NFET N42. The third NFET N43 and the fourth NFET N44 may be referred to as pass transistors configured to respectively connect the first inverter and the second inverter to the second bit line BL2 and the second complementary bit line BLB2 by a word line WL[k+1] that is activated (e.g., having a high-level voltage).

When an IR drop occurs at the node to which the positive supply voltage VDD is applied or at the node to which the negative supply voltage VSS is applied, the memory cell C11 may not appropriately output a signal corresponding to a value latched in the pair of cross-coupled inverters to the first bit line BL1 and the first complementary bit line BLB 1, and may not appropriately latch a value corresponding to the signal applied to the first bit line BL1 and the first complementary bit line BLB 1 to the pair of cross-coupled inverters. As the number of memory cells in one row increases, the word line may extend, and the influence of a parasitic resistance of the word line may increase. Accordingly, a memory cell remote from the row driver 34 of FIG. 3 may identify activation of the word line at a delayed point in time, and an operation speed of the memory device 30 of FIG. 3 may be limited.

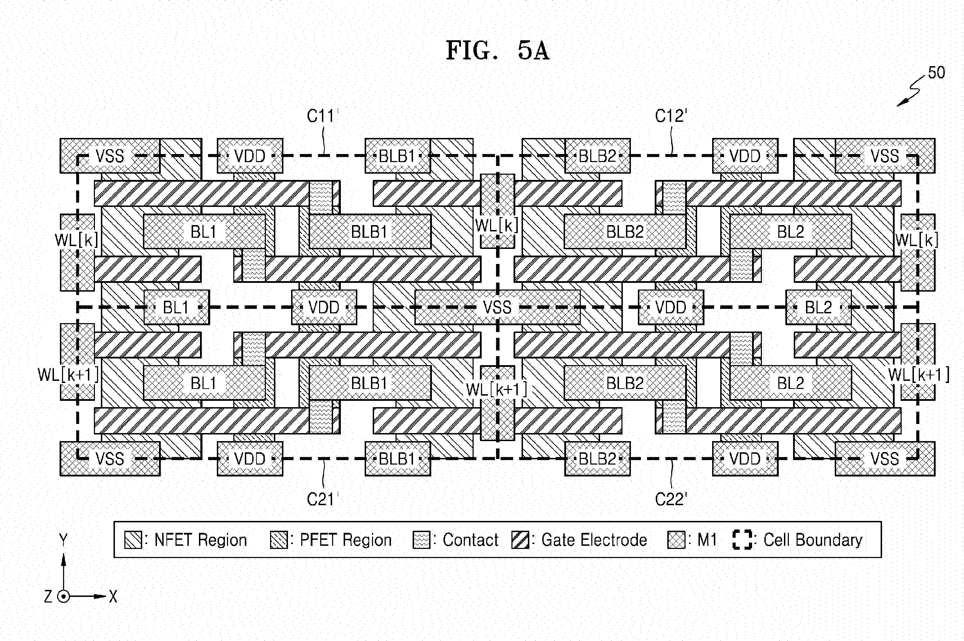

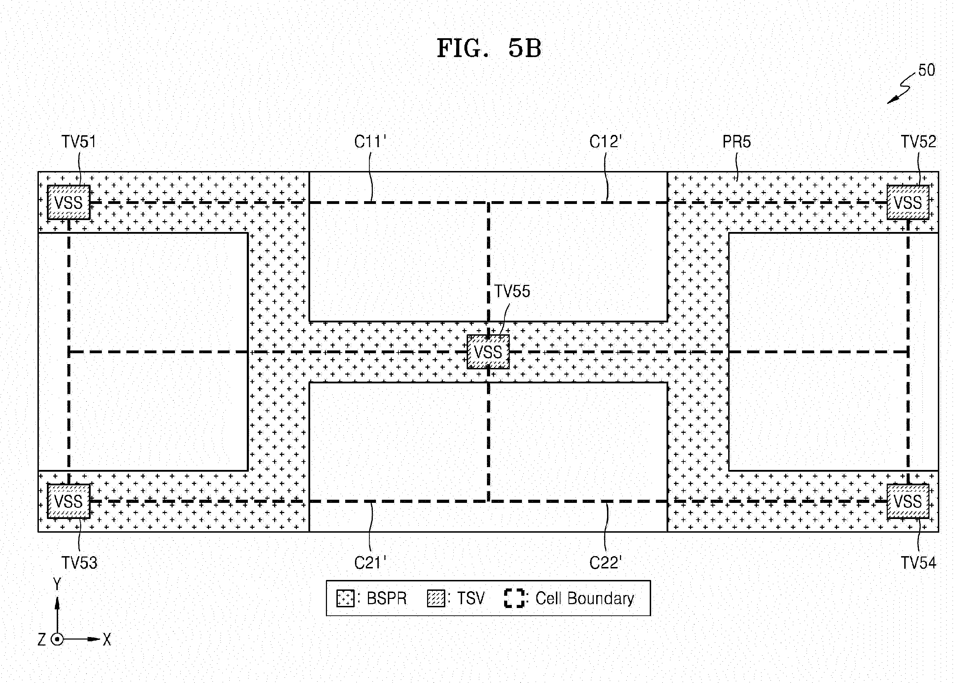

FIGS. 5A and 5B are plan views of a layout illustrating an IC according to some embodiments. For example, the plan views of FIGS. 5A and 5B illustrate a layout 50 including memory cells C11', C12', C21', and C22' corresponding respectively to the four memory cells C11, C12, C21, and C22 included in the equivalent circuit 40 of FIG. 4. The plan view of FIG. 5A illustrates a cell array in the layout 50, and the plan view of FIG. 5B illustrates a power rail disposed under the cell array and TSVs disposed under the power rail in the layout 50. In FIGS. 5A and 5B, a name written on a pattern denotes a line electrically connected to the pattern and/or a voltage applied to the pattern. For brevity, the illustration of a source/drain is omitted in FIG. 5A. It is noted that the equivalent circuit 40 of FIG. 4 is not limited to the layout 50 shown in FIGS. 5A and 5B.

Referring to FIG. 5A, each of the four memory cells C11', C12', C21', and C22' may have the same footprint. That is, each of the four memory cells C11', C12', C21', and C22' may have the same area, the same horizontal length, and the same vertical length. The memory cell C11' and the memory cell C12', which are in the same row, may be connected in common to a word line WL[k]. The memory cell C21' and the memory cell C22', which are in the same row, may be connected in common to a word line WL[k+1]. The memory cell C11' and the memory cell C21', which are in the same column, may be connected in common to a first bit line BL1 and a first complementary bit line BLB1. The memory cell C12' and the memory cell C22', which are in the same column, may be connected in common to a second bit line BL2 and a second complementary bit line BLB2.

The memory cell C11' may include an NFET region and a PFET region, which extend in a Y-axis direction. For example, as shown in FIG. 5A, NFET regions may extend in the Y-axis direction between PFET regions, which extend in the Y-axis direction in the memory cell C11'. The memory cell C11' may include a gate electrode extending in an X-axis direction. The gate electrode may form NFETs (i.e., the first to fourth NFETs N11 to N14 of FIG. 4) in the NFET region, and form PFETs (i.e., the first and second PFETs P11 and P12 of FIG. 4) in the PFET region. Source/drains may be formed on both sides of the gate electrode, and the source/drain may be connected to a pattern of an M1 layer through a contact (referred to as a source/drain contact) and a via. The gate electrode may be connected to the pattern of the M1 layer through a contact (referred to as a gate contact) and a via.

The memory cell C12' may include an NFET region and a PFET region, which extend in the Y-axis direction. For example, as shown in FIG. 5A, NFET regions may extend in the Y-axis direction between PFET regions, which extend in the Y-axis direction in the memory cell C12'. The memory cell C12' may include a gate electrode extending in the X-axis direction. The gate electrode may form NFETs (i.e., the first to fourth NFETs N21 to N24 of FIG. 4) in the NFET region, and form PFETs (i.e., the first and second PFETs P21 and P22) in the PFET region. Source/drains may be formed on both sides of the gate electrode, and the source/drain may be connected to a pattern of an M1 layer through a contact (referred to as a source/drain contact) and a via. The gate electrode may be connected to the pattern of the M1 layer through the contact and the via.

The memory cell C21' may include an NFET region and a PFET region, which extend in the Y-axis direction. For example, as shown in FIG. 5A, NFET regions may extend in the Y-axis direction between PFET regions, which extend in the Y-axis direction in the memory cell C21'. the memory cell C21' may include a gate electrode extending in the X-axis direction. The gate electrode may form NFETs (i.e., the first to fourth NFETs N31 to N34 of FIG. 4) in the NFET region, and form PFETs (i.e., the first and second PFETs P31 and P32 of FIG. 4) in the PFET region. Source/drains may be formed on both sides of the gate electrode, and the source/drain may be connected to a pattern of an M1 layer through a contact and a via. The gate electrode may be connected to the pattern of the M1 layer through the contact and the via.

The memory cell C22' may include an NFET region and a PFET region, which extend in the Y-axis direction. For example, as shown in FIG. 5A, NFET regions may extend in the Y-axis direction between PFET regions, which extend in the Y-axis direction in the memory cell C22'. The memory cell C22' may include a gate electrode extending in the X-axis direction. The gate electrode may form NFETs (i.e., the first to fourth NFETs N41 to N44 of FIG. 4) in the NFET region, and form PFETs (i.e., the first and second PFETs P41 and P42 of FIG. 4) in the PFET region. Source/drains may be formed on both sides of the gate electrode, and the source/drain may be connected to a pattern of an M1 layer through a contact and a via. The gate electrode may be connected to the pattern of the M1 layer through the contact and the via.

In some embodiments, memory cells included in the layout 50 may have mutually flipped layouts. For example, a layout of the memory cell C1 1' may be symmetrical with a layout of the memory cell C12' about a boundary between the memory cell C11' and the memory cell C 12'. That is, the layout of the memory cell C1 1' may correspond to a layout obtained by flipping the layout of the memory cell C12' about an axis parallel to a Y-axis. The layout of the memory cell C11' may be symmetrical with a layout of the memory cell C21' about a boundary between the memory cell C11' and the memory cell C21'. That is, the layout of the memory cell C11' may correspond to a layout obtained by flipping the layout of the memory cell C21' about an axis parallel to an X-axis. The layout of the memory cell C12' may be symmetrical with a layout of the memory cell C22' about a boundary between the memory cell C12' and the memory cell C22'. That is, the layout of the memory cell C12' may correspond to a layout obtained by flipping the layout of the memory cell C22' about the axis parallel to the X-axis.

Referring to FIG. 5B, a power rail PR5 to which a negative supply voltage VSS is applied may be under the cell array of FIG. 5A, and a first TSV TV51, a second TSV TV52, a third TSV TV53, a fourth TSV TV54, and a fifth TSV TV55 may be arranged on the power rail PR5. In some embodiments, as described above with reference to FIG. 1A, a TSV may have a top surface connected to the pattern of the M1 layer and a bottom surface connected to a BSPR. For example, each of the first to fifth TSVs TV51 to TV55 may have a bottom surface connected to the power rail PR5 and a top surface connected to the pattern of the M1 layer to which the negative supply voltage VSS is applied in FIG. 5A.

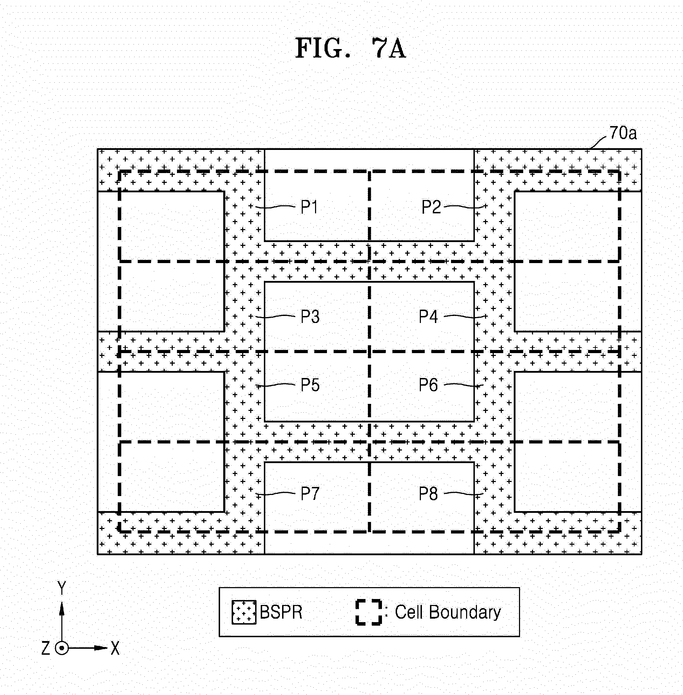

In some embodiments, the TSV may be on a boundary between memory cells that are adjacent to each other. For example, as shown in FIG. 5B, the first to fifth TSVs TV51 to TV55 may overlap a boundary of at least one of the memory cells C11', C12', C21', and C22'. In some embodiments, the TSV may be shared by the memory cells that are adjacent to each other. For example, the fifth TSV TV55 may be shared among the memory cells C11', C12', C21', and C22'. As in non-limiting examples presented with reference to FIGS. 7A to 7D, the power rail PR5 may have various shapes not limited to FIG. 5B. In some embodiments, like the memory cells described with reference to FIG. 5A, portions partitioned by the boundaries of the memory cells in the power rail PR5 may have mutually flipped layouts.

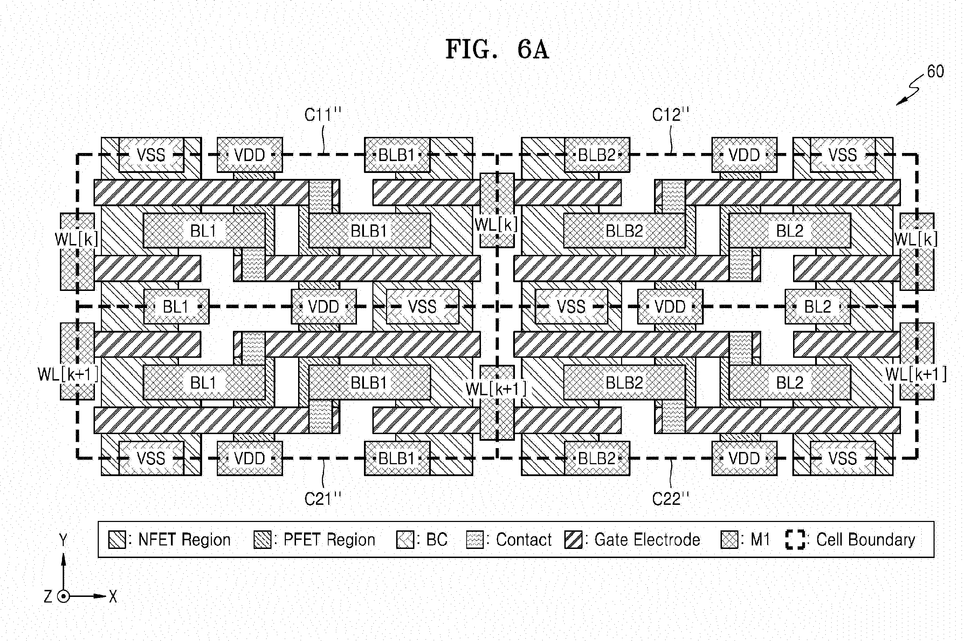

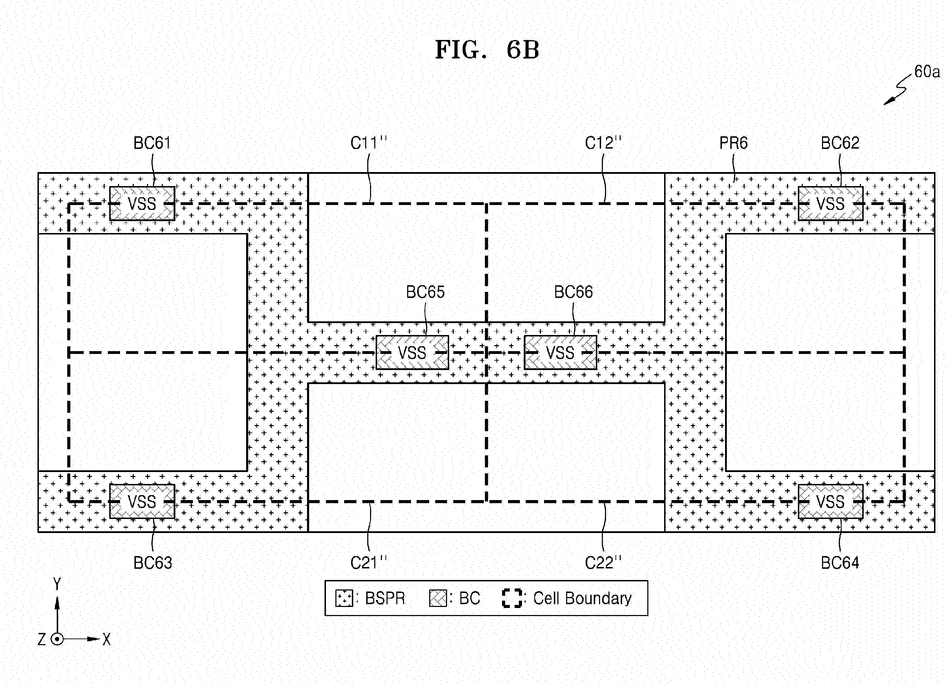

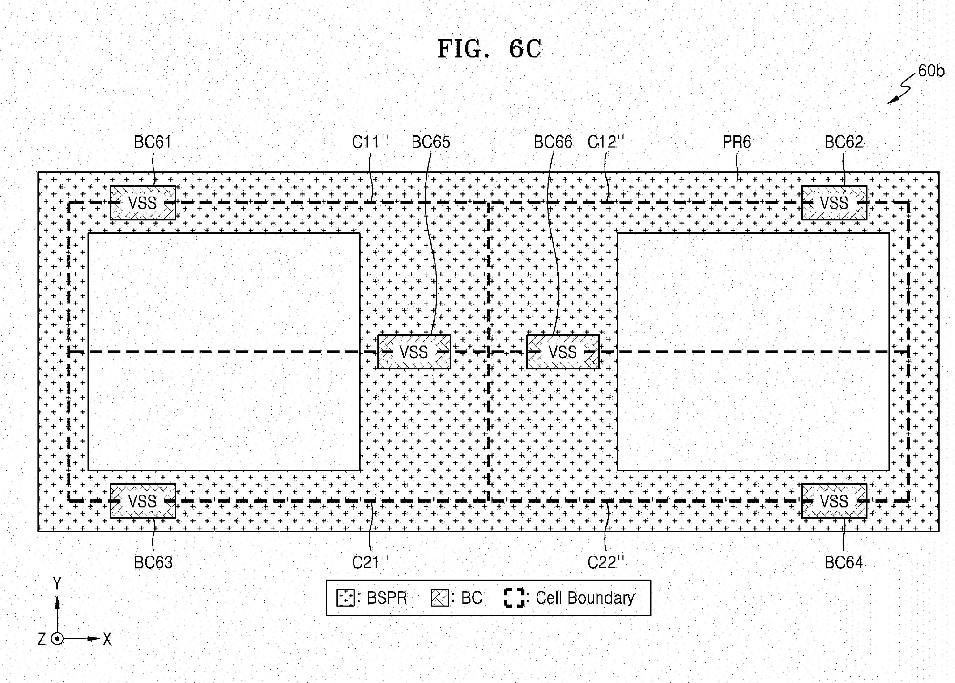

FIGS. 6A to 6C are plan views of a layout of an IC according to some embodiments. For example, the plan view of FIGS. 6Aillustrates a layout 60 including memory cells C11", C12", C21", and C22", which respectively correspond to the four memory cells C11, C12, C21, and C22 included in the equivalent circuit 40 of FIG. 4, and backside contacts. The plan view of FIG. 6A illustrates a cell array in the layout 60, and the plan views of FIGS. 6B and 6C illustrate layouts 60a and 60b each including a power rail and backside contacts, which may be disposed under the cell array. In FIGS. 6A to 6C, a name written on a pattern denotes a line electrically connected to the pattern and/or a voltage applied to the pattern. For brevity, the illustration of a source/drain is omitted in FIG. 6A. It is noted that the equivalent circuit 40 of FIG. 4 is not limited to the layout 60 shown in FIGS. 6A to 6C.

Referring to FIG. 6A, each of the four memory cells C11", C12", C21", and C22" may have the same footprint. That is, each of the four memory cells C 11", C12", C21", and C22" may have the same area, the same horizontal length, and the same vertical length. The memory cell C11" and the memory cell C12", which are in the same row, may be connected in common to a word line WL[k]. The memory cell C21" and the memory cell C22", which are in the same row, may be connected in common to a word line WL[k+1]. The memory cell C11" and the memory cell C21", which are in the same column, may be connected in common to a first bit line BL1 and a first complementary bit line BLB1. The memory cell C12" and the memory cell C22", which are in the same column, may be connected in common to a second bit line BL2 and a second complementary bit line BLB2.

The memory cell C11" may include an NFET region and a PFET region, which extend in a Y-axis direction. For example, as shown in FIG. 6A, NFET regions may extend in the Y-axis direction between PFET regions, which extend in the Y-axis direction in the memory cell C11". The memory cell C11" may include a gate electrode extending in an X-axis direction. The gate electrode may form NFETs (i.e., the first to fourth NFETs N11 to N14 of FIG. 4) in the NFET region and form PFETs (i.e., the first PFET P11 and the second PFET P12 of FIG. 4) in the PFET region. Source/drains may be formed on both sides of the gate electrode, and the source/drain may be connected to a pattern of an M1 layer through a contact (referred to as a source/drain contact) and a via. The gate electrode may be connected to the pattern of the M1 layer through a contact (referred to as a gate contact) and a via.

The memory cell C12" may include an NFET region and a PFET region, which extend in the Y-axis direction. For example, as shown in FIG. 6A, NFET regions may extend in the Y-axis direction between PFET regions, which extend in the Y-axis direction in the memory cell C12". The memory cell C12" may include a gate electrode extending in the X-axis direction. The gate electrode may form NFETs (i.e., the first to fourth NFETs N21 to N24 of FIG. 4) in the NFET region and form PFETs (i.e., the first PFET P21 and the second PFET P22 of FIG. 4) in the PFET region. Source/drains may be formed on both sides of the gate electrode, and the source/drain may be connected to a pattern of an M1 layer through a contact and a via. The gate electrode may be connected to the pattern of the M1 layer through the contact and the via.

The memory cell C21" may include an NFET region and a PFET region, which extend in the Y-axis direction. For example, as shown in FIG. 6A, NFET regions may extend in the Y-axis direction between PFET regions, which extend in the Y-axis direction in the memory cell C21". The memory cell C21" may include a gate electrode extending in the X-axis direction. The gate electrode may form NFETs (i.e., the first to fourth NFETs N31 to N34 of FIG. 4) in the NFET region and form PFETs (i.e., the first PFET P31 and the second PFET P32 of FIG. 4) in the PFET region. Source/drains may be formed on both sides of the gate electrode, and the source/drain may be connected to a pattern of an M1 layer through a contact and a via. The gate electrode may be connected to the pattern of the M1 layer through the contact and the via.

The memory cell C22" may include an NFET region and a PFET region, which extend in the Y-axis direction. For example, as shown in FIG. 6A, NFET regions may extend in the Y-axis direction between PFET regions, which extend in the Y-axis direction in the memory cell C22". The memory cell C22" may include a gate electrode extending in the X-axis direction. The gate electrode may form NFETs (i.e., the first to fourth NFETs N41 to N44 of FIG. 4) in the NFET region, and form PFETs (i.e., the first PFET P41 and the second PFET P42 of FIG. 4) in the PFET region. Source/drains may be formed on both sides of the gate electrode, and the source/drain may be connected to a pattern of an M1 layer through a contact and a via. The gate electrode may be connected to the pattern of the M1 layer through the contact and the via.

In some embodiments, memory cells included in the layout 60 may have mutually flipped layouts. For example, a layout of the memory cell C11" may be symmetrical with a layout of the memory cell C12" about a boundary between the memory cell C11" and the memory cell C12". That is, the layout of the memory cell C11" may correspond to a layout obtained by flipping the layout of the memory cell C12" about an axis parallel to a Y-axis. The layout of the memory cell C11" may be symmetrical with a layout of the memory cell C21" about a boundary between the memory cell C I I " and the memory cell C21". That is, the layout of the memory cell C11" may correspond to a layout obtained by flipping the layout of the memory cell C21" about an axis parallel to an X-axis. The layout of the memory cell C12" may be symmetrical with a layout of the memory cell C22" about a boundary between the memory cell C12" and the memory cell C22". That is, the layout of the memory cell C12" may correspond to a layout obtained by flipping the layout of the memory cell C22" about the axis parallel to the X-axis.

As compared to the layout 50 of FIG. 5A, in the layout 60, patterns of the M1 layer to which a negative supply voltage VSS is applied may be omitted. As shown in FIG. 6A, the negative supply voltage VSS may be provided to a source/drain of a transistor by backside contacts. Thus, the patterns of the M1 layer to which the negative supply voltage VSS is applied may be omitted.

Referring to FIG. 6B, a power rail PR6 to which the negative supply voltage VSS is applied may be under the cell array of FIG. 6A, and a first backside contact BC61, a second backside contact BC62, a third backside contact BC63, a fourth backside contact BC64, a fifth backside contact BC65, and a sixth backside contact BC66 may be arranged on the power rail PR6. In some embodiments, as described above with reference to FIG. 1B, a backside contact may have a top surface connected to a source/drain and a bottom surface connected to a BSPR. For example, each of the first to sixth backside contacts BC61 to BC66 may have a bottom surface connected to the power rail PR6 and a top surface connected to the source/drain (or source) of the transistor in FIG. 6A.

In some embodiments, the backside contact may be on a boundary between memory cells that are adjacent to each other. For example, as shown in FIG. 6B, the first to sixth backside contacts BC61 to BC66 may overlap a boundary of at least one of the memory cells C11", C12", C21", and C22". In some embodiments, the backside contact may be shared by the memory cells that are adjacent to each other. For example, the fifth backside contact BC65 may be shared by the memory cell C11" and the memory cell C21", and the sixth backside contact BC66 may be shared by the memory cell C12" and the memory cell C22".

Referring to FIG. 6C, a power rail PR6 to which the negative supply voltage VSS is applied may be under the cell array of FIG. 6A, and a first backside contact BC61, a second backside contact BC62, a third backside contact BC63, a fourth backside contact BC64, a fifth backside contact BC65, and a sixth backside contact BC66 may be arranged on the power rail PR6. In some embodiments, as described above with reference to FIG. 1B, a backside contact may have a top surface connected to a source/drain and a bottom surface connected to a BSPR. For example, each of the first to sixth backside contacts BC61 to BC66 may have a bottom surface connected to the power rail PR6 and a top surface connected to the source/drain (or source) of the transistor in FIG. 6A.

In some embodiments, the backside contact may be on a boundary between memory cells that are adjacent to each other. For example, as shown in FIGS. 6B and 6C, the first to sixth backside contacts BC61 to BC66 may overlap a boundary of at least one of the memory cells C11", C12", C21", and C22". In some embodiments, the backside contact may be shared by the memory cells that are adjacent to each other. For example, the fifth backside contact BC65 may be shared by the memory cell C I I " and the memory cell C21", and the sixth backside contact BC66 may be shared by the memory cell C12" and the memory cell C22". As in non-limiting examples presented with reference to FIGS. 7A to 7D, the power rail PR6 may have various shapes not limited to FIGS. 6B and 6C. In some embodiments, like the memory cells described with reference to FIG. 6A, portions partitioned by the boundaries of the memory cells in the power rail PR6 may have mutually flipped layouts.

FIGS. 7A to 7D are plan views of examples of a BSPR according to some embodiments. As described above with reference to the drawings, the BSPR may be under a cell array, and a TSV or a backside contact may be on the BSPR. It is noted that the BSPR is not limited to examples shown in FIGS. 7A to 7D.

Referring to FIG. 7A, a power rail 70a may have a shape according to a cell boundary. For example, the power rail 70a may include a first portion P1, a second portion P2, a third portion P3, a fourth portion P4, a fifth portion P5, a sixth portion P6, a seventh portion P7, and an eighth portion P8 partitioned according to the cell boundary, and the first to eighth portions P1 to P8 may respectively have mutually flipped shapes. The first portion P1 may be symmetrical with the second portion P2 about a cell boundary between the first portion P1 and the second portion P2. That is, the first portion P1 may correspond to a shape in which the second portion P2 is flipped about an axis parallel to a Y-axis. The first portion P1 may be symmetrical with the third portion P3 about a cell boundary between the first portion P1 and the third portion P3. That is, the first portion P1 may correspond to a shape in which the third portion P3 is flipped about an axis parallel to an X-axis. The second portion P2 may be symmetrical with the fourth portion P4 about a cell boundary between the second portion P2 and the fourth portion P4. That is, the second portion P2 may correspond to a shape in which the fourth portion P4 is flipped about the axis parallel to the X-axis. The fifth to eighth portions P5 to P8 may have the same shape as the first to fourth portions P1 to P4, respectively, and thus repeated description thereof is omitted for conciseness. In the example shown in Figure 7A, the second portion P2 has an S-shape within the cell boundary when viewed in the X-Y plane, and the first portion P1 has an inverted-S-shape within the cell boundary when viewed in the X-Y plane. Each of the first portion P1, fourth portion P4, fifth portion P5 and eighth portion P8 have the same shape in the X-Y plane, and each of the second portion P2, third portion P3, sixth portion P6 and seventh portion P7 have the same shape in the X-Y plane.

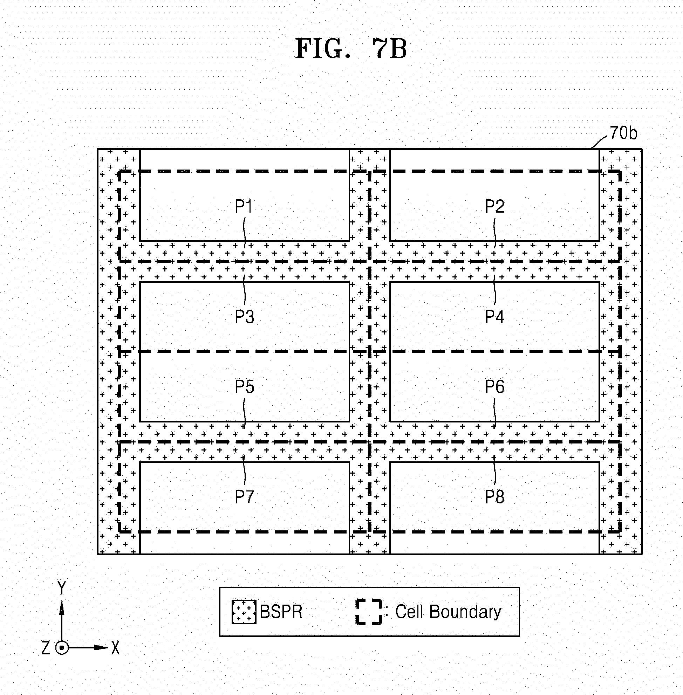

Referring to FIG. 7B, a power rail 70b may have a shape according to a cell boundary. For example, the power rail 70b may include a first portion P1, a second portion P2, a third portion P3, a fourth portion P4, a fifth portion P5, a sixth portion P6, a seventh portion P7, and an eighth portion P8 partitioned according to the cell boundary, and the first to eighth portions P1 to P8 may respectively have mutually flipped shapes. The first portion P1 may be symmetrical with the second portion P2 about a cell boundary between the first portion P1 and the second portion P2. That is, the first portion P1 may correspond to a shape in which the second portion P2 is flipped about an axis parallel to a Y-axis. The first portion P1 may be symmetrical with the third portion P3 about a cell boundary between the first portion P1 and the third portion P3. That is, the first portion P1 may correspond to a shape in which the third portion P3 is flipped about an axis parallel to an X-axis. The second portion P2 may be symmetrical with the fourth portion P4 about a cell boundary between the second portion P2 and the fourth portion P4. That is, the second portion P2 may correspond to a shape in which the fourth portion P4 is flipped about the axis parallel to the X-axis. The fifth to eighth portions P5 to P8 may have the same shape as the first to fourth portions P1 to P4, respectively, and thus a repeated description thereof is omitted for conciseness. In the example shown in Figure 7B, the first portion P1 has a U-shape within the cell boundary when viewed in the X-Y plane, and the third portion P3 has an inverted-U-shape within the cell boundary when viewed in the X-Y plane. Each of the first portion P1, second portion P2, fifth portion P5 and sixth portion P6 have the same shape in the X-Y plane, and each of the third portion P3, fourth portion P4, seventh portion P7 and eighth portion P8 have the same shape in the X-Y plane.

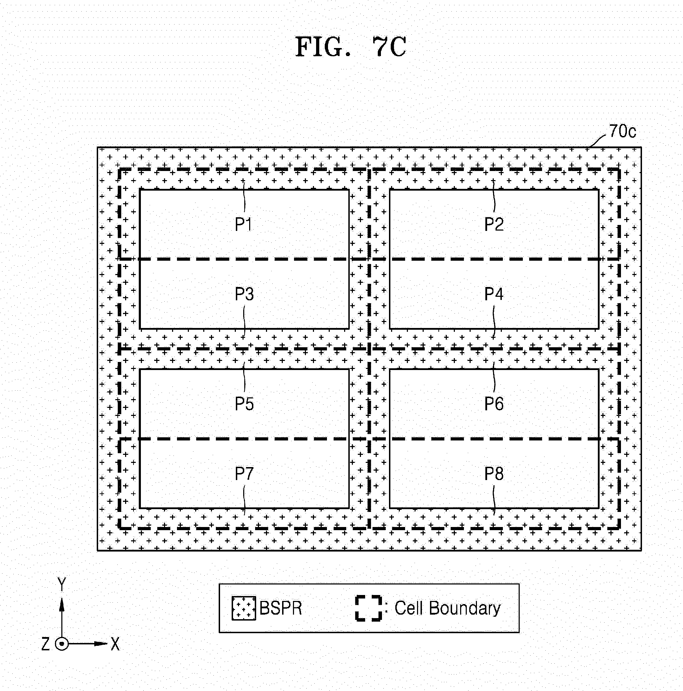

Referring to FIG. 7C, a power rail 70c may have a shape according to a cell boundary. For example, the power rail 70c may include a first portion P1, a second portion P2, a third portion P3, a fourth portion P4, a fifth portion P5, a sixth portion P6, a seventh portion P7, and an eighth portion P8 partitioned according to the cell boundary, and the first to eighth portions P1 to P8 may respectively have mutually flipped shapes. The first portion P1 may be symmetrical with the second portion P2 about a cell boundary between the first portion P1 and the second portion P2. That is, the first portion P1 may correspond to a shape in which the second portion P2 is flipped about an axis parallel to a Y-axis. The first portion P1 may be symmetrical with the third portion P3 about a cell boundary between the first portion P1 and the third portion P3. That is, the first portion P1 may correspond to a shape in which the third portion P3 is flipped about an axis parallel to an X-axis. The second portion P2 may be symmetrical with the fourth portion P4 about a cell boundary between the second portion P2 and the fourth portion P4. That is, the second portion P2 may correspond to a shape in which the fourth portion P4 is flipped about the axis parallel to the X-axis. The fifth to eighth portions P5 to P8 may have the same shape as the first to fourth portions P1 to P4, respectively, and thus a repeated description thereof is omitted for conciseness. In the example shown in Figure 7C, the first portion P1 has an inverted-U-shape within the cell boundary when viewed in the X-Y plane, and the third portion P3 has a U-shape within the cell boundary when viewed in the X-Y plane. Each of the first portion P1, second portion P2, fifth portion P5 and sixth portion P6 have the same shape in the X-Y plane, and each of the third portion P3, fourth portion P4, seventh portion P7 and eighth portion P8 have the same shape in the X-Y plane.

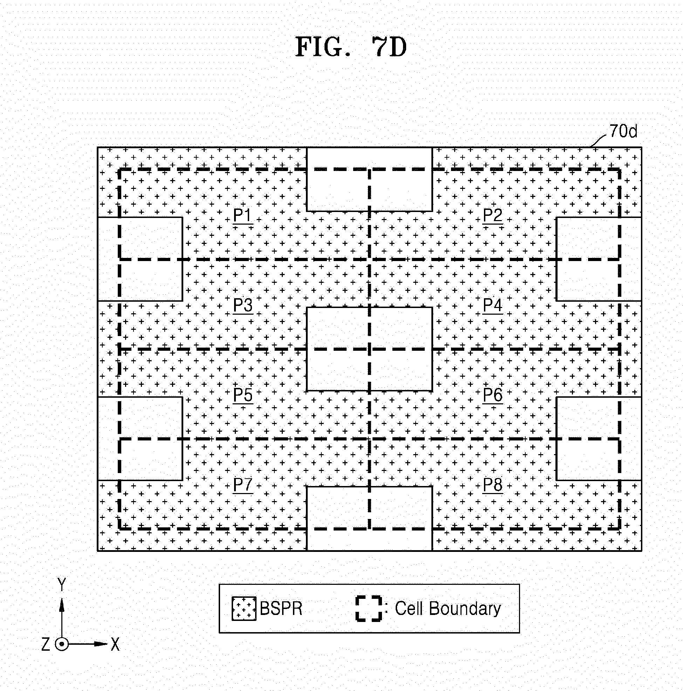

Referring to FIG. 7D, a power rail 70d may have a shape according to a cell boundary. For example, the power rail 70d may include a first portion P1, a second portion P2, a third portion P3, a fourth portion P4, a fifth portion P5, a sixth portion P6, a seventh portion P7, and an eighth portion P8 partitioned according to the cell boundary, and the first to eighth portions P1 to P8 may respectively have mutually flipped shapes. The first portion P1 may be symmetrical with the second portion P2 about a cell boundary between the first portion P1 and the second portion P2. That is, the first portion P1 may correspond to a shape in which the second portion P2 is flipped about an axis parallel to a Y-axis. The first portion P1 may be symmetrical with the third portion P3 about a cell boundary between the first portion P1 and the third portion P3. That is, the first portion P1 may correspond to a shape in which the third portion P3 is flipped about an axis parallel to an X-axis. The second portion P2 may be symmetrical with the fourth portion P4 about a cell boundary between the second portion P2 and the fourth portion P4. That is, the second portion P2 may correspond to a shape in which the fourth portion P4 is flipped about the axis parallel to the X-axis. The fifth to eighth portions P5 to P8 may have the same shape as the first to fourth portions P1 to P4, respectively, and thus a repeated description thereof is omitted for conciseness. In the example shown in Figure 7D, the second portion P2 has an S-shape within the cell boundary when viewed in the X-Y plane, and the first portion P1 has an inverted-S-shape within the cell boundary when viewed in the X-Y plane. Each of the first portion P1, fourth portion P4, fifth portion P5 and eighth portion P8 have the same shape in the X-Y plane, and each of the second portion P2, third portion P3, sixth portion P6 and seventh portion P7 have the same shape in the X-Y plane. The S-shape of Figure 7D is thicker in cross-section than the S-shape of Figure 7A.

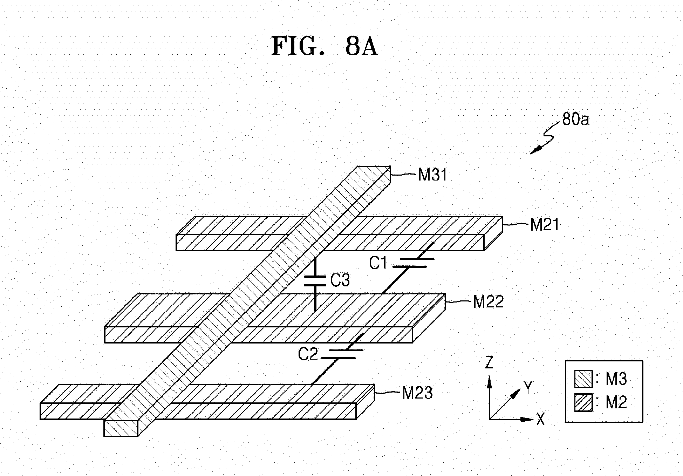

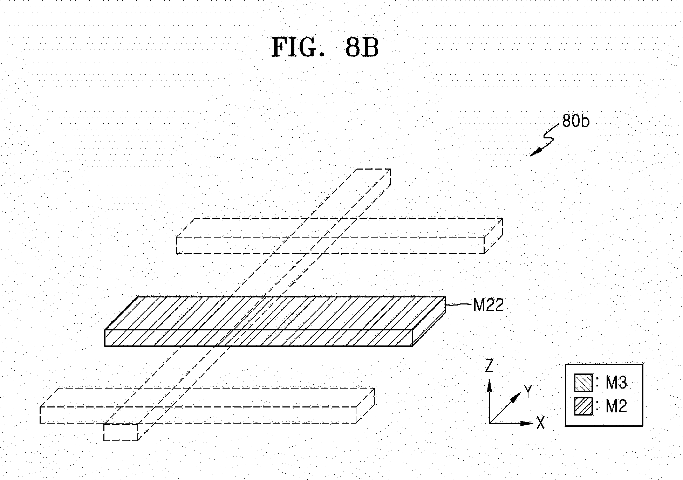

FIGS. 8A and 8B are diagrams of examples of a layout of an IC according to some embodiments. For example, FIGS. 8A and 8B illustrate layouts 80a and 80b, each of which includes a word line extending on a memory cell array. As shown in FIGS. 8A and 8B, a second pattern M22 corresponding to the word line may extend in an X-axis direction and be electrically connected to a plurality of memory cells.

Referring to FIG. 8A, when a BSPR is not used, a negative supply voltage VSS may be provided to the memory cell through patterns of a wiring layer. To this end, as shown in FIG. 8A, in an M2 layer, a first pattern M21 and a third pattern M23 to which the negative supply voltage VSS is applied may extend in the X-axis direction, and the second pattern M22 corresponding to the word line may extend between the first pattern M21 and the third pattern M23 in the M2 layer. In an M3 layer, a pattern M31 to which the negative supply voltage VSS is applied may extend in a Y-axis direction. Accordingly, as shown in FIG. 8A, a first parasitic capacitance C1 may occur between the second pattern M22 and the first pattern M21, a second parasitic capacitance C2 may occur between the second pattern M22 and the third pattern M23, and a third parasitic capacitance C3 may occur between the second pattern M22 and the pattern M31. Due to parasitic capacitances including the first to third parasitic capacitances C1 to C3, activation (e.g., a voltage rise) and deactivation (e.g., a voltage drop) of the word line through the second pattern M22 may be delayed.

Referring to FIG. 8B, as described above with reference to the drawings, when the BSPR is used, patterns configured to provide the negative supply voltage VSS may be omitted in the wiring layer. For example, as shown in FIG. 8B, in an M2 layer, only the second pattern M22 corresponding to the word line may extend in the X-axis direction. That is, in the M2 layer, a pattern may be omitted between adjacent patterns corresponding to word lines. Furthermore, in an M3 layer, a pattern to which the negative supply voltage VSS is applied may be omitted. As a result, a parasitic capacitance between the second pattern M22 and a pattern adjacent thereto may be markedly reduced, and the activation and the deactivation of the word line through the second pattern M22 may be performed at high speed.

FIG. 9 is a block diagram of a System-on-Chip (SoC) according to some embodiments. A SoC may refer to an IC in which components of a computing system or another electronic system are integrated. For example, an application processor (AP), which is an example of the SoC, may include a processor and components for other functions. As shown in FIG. 9, a SoC 90 may include a core 91, a digital signal processor (DSP) 92, a graphic processing unit (GPU) 93, an embedded memory 94, a communication interface (I/F) 95, and a memory interface (I/F) 96. The components of the SoC 90 may communicate with each other through a bus 97.

The core 91 may process instructions and control operations of the components included in the SoC 90. For example, the core 91 may drive an operating system and execute applications on the operating system by processing a series of instructions. The DSP 92 may generate data by processing a digital signal (e.g., a digital signal provided by the communication interface 95). The GPU 93 may generate data corresponding to an image output by a display device, based on image data provided by the embedded memory 94 or the memory interface 96, or encode the image data. In some embodiments, the memory device described above with reference to FIGS. 1A-7D may be included as a cache memory and/or a memory in the core 91, the DSP 92, and/or the GPU 93. Accordingly, due to high reliability and efficiency of the memory device, the core 91, the DSP 92, and/or the GPU 93 may also have high reliability and efficiency.

The embedded memory 94 may store data required for operations of the core 91, the DSP 92, and the GPU 93. In some embodiments, the embedded memory 94 may include a memory device described above with reference to FIGS. 1A-7D. Thus, the embedded memory 94 may provide a reliable write operation and have a reduced area and reduced power consumption. As a result, operation reliability and efficiency of the SoC 90 may improve.

The communication interface 95 may provide an interface for a communication network or one-to-one communication. The memory interface 96 may provide an interface for an external memory (e.g., DRAM and flash memory) of the SoC 90.

While various embodiments have been particularly shown and described with reference to drawings, it will be understood that various changes in form and details may be made therein without departing from the scope of the following claims.

Further Embodiments are set out in the following Numbered Paragraphs (NPs):
NP1. An integrated circuit comprising:
   a cell array comprising a plurality of cells, each of the plurality of cells including at least one transistor;
   a power rail in a power rail layer under the cell array, the power rail being configured to provide power to the cell array; and
   a plurality of contacts between the cell array and the power rail,
   wherein each of the plurality of contacts extends downward from a source of a transistor of a corresponding one of the plurality of cells to the power rail.
NP2. The integrated circuit of NP1, wherein each of the plurality of contacts is at a boundary between adjacent cells of the plurality of cells, and is shared by the adjacent cells.
NP3. The integrated circuit of NP1, wherein each of the plurality of cells has a same footprint, and
   the plurality of contacts are arranged on the power rail.
NP4. The integrated circuit of NP1, wherein the plurality of cells comprise a first cell and a second cell adjacent to the first cell, and
   the first cell and the second cell are symmetrical with each other about a boundary between the first cell and the second cell.
NP5. The integrated circuit of NP4, wherein the power rail comprises a first portion under the first cell and a second portion under the second cell, and
   the first portion and the second portion are symmetrical with each other about a boundary between the first portion and the second portion.
NP 6. The integrated circuit of NP4, wherein the plurality of cells further comprise a third cell adjacent to the first cell and a fourth cell adjacent to the second cell,
   the first cell and the third cell are symmetrical with each other about a boundary between the first cell and the third cell, and
   the second cell and the fourth cell are symmetrical with each other about a boundary between the second cell and the fourth cell.
NP 7. The integrated circuit of NP6, wherein the power rail comprises a first portion under the first cell and a second portion under the second cell,
   the first portion and the second portion are symmetrical with each other about a boundary between the first portion and the second portion,
   the power rail further comprises a third portion under the third cell and a fourth portion under the fourth cell,
   the first portion and the third portion are symmetrical with each other about a boundary between the first portion and the third portion, and
   the second portion and the fourth portion are symmetrical with each other about a boundary between the second portion and the fourth portion.
NP8. The integrated circuit of NP1, wherein the plurality of cells are configured to operate based on a positive supply voltage and a negative supply voltage, and
   the power rail is configured to receive the negative supply voltage.
NP9. The integrated circuit of NP1, further comprising a plurality of word lines extending parallel to each other in a first horizontal direction in a first wiring layer over the cell array,
   wherein, in the first wiring layer, a pattern between adjacent word lines, from among the plurality of word lines, is omitted.
NP10. An integrated circuit comprising:
   a cell array comprising a plurality of cells, each of the plurality of cells including at least one transistor;
   a power rail in a power rail layer under the cell array, the power rail being configured to provide power to the cell array; and
   a plurality of contacts between the cell array and the power rail,
   wherein each of the plurality of contacts has a top surface connected to a source of a transistor of a corresponding one of the plurality of cells and a bottom surface connected to the power rail.
NP11. The integrated circuit of NP10, wherein each of the plurality of contacts is at a boundary between adjacent cells of the plurality of cells and is shared by the adjacent cells.
NP12. The integrated circuit of NP10, wherein each of the plurality of cells has a same footprint, and the plurality of contacts are arranged on the power rail.
NP13. The integrated circuit of NP10, wherein the plurality of cells comprise a first cell and a second cell adjacent to the first cell, and
   the first cell and the second cell are symmetrical with each other about a boundary between the first cell and the second cell.
NP14. The integrated circuit of NP10, wherein the plurality of cells are each configured to operate based on a positive supply voltage and a negative supply voltage, and
   the power rail is configured to receive the negative supply voltage.
NP15. The integrated circuit of NP10, further comprising a plurality of word lines extending parallel to each other in a first horizontal direction in a first wiring layer over the cell array,
   wherein, in the first wiring layer, a pattern between adjacent word lines of the plurality of word lines is omitted.

## Claims

1. An integrated circuit comprising:
a cell array comprising a plurality of cells, each of the plurality of cells including at least one transistor;
a power rail in a power rail layer under the cell array, the power rail being configured to provide power to the cell array; and
a plurality of contacts between the cell array and the power rail,
wherein each of the plurality of contacts extends downward from a source or a drain of a transistor of a corresponding one of the plurality of cells to the power rail.

2. The integrated circuit of claim 1, wherein each of the plurality of contacts is at a boundary between adjacent cells of the plurality of cells, and is shared by the adjacent cells.

3. The integrated circuit of claim 1 or claim 2, wherein each of the plurality of cells has a same footprint, and
the plurality of contacts are arranged on the power rail.

4. The integrated circuit of any preceding claim, wherein the plurality of cells comprise a first cell and a second cell adjacent to the first cell, and
the first cell and the second cell are symmetrical with each other about a boundary between the first cell and the second cell.

5. The integrated circuit of claim 4, wherein the power rail comprises a first portion under the first cell and a second portion under the second cell, and
the first portion and the second portion are symmetrical with each other about a boundary between the first portion and the second portion.

6. The integrated circuit of claim 4, wherein the plurality of cells further comprise a third cell adjacent to the first cell and a fourth cell adjacent to the second cell,
the first cell and the third cell are symmetrical with each other about a boundary between the first cell and the third cell, and
the second cell and the fourth cell are symmetrical with each other about a boundary between the second cell and the fourth cell.

7. The integrated circuit of claim 6, wherein the power rail comprises a first portion under the first cell and a second portion under the second cell,
the first portion and the second portion are symmetrical with each other about a boundary between the first portion and the second portion,
the power rail further comprises a third portion under the third cell and a fourth portion under the fourth cell,
the first portion and the third portion are symmetrical with each other about a boundary between the first portion and the third portion, and
the second portion and the fourth portion are symmetrical with each other about a boundary between the second portion and the fourth portion.

8. The integrated circuit of any preceding claim, wherein the plurality of cells are configured to operate based on a positive supply voltage and a negative supply voltage, and
the power rail is configured to receive the negative supply voltage.

9. The integrated circuit of any preceding claim, further comprising a plurality of word lines extending parallel to each other in a first horizontal direction in a first wiring layer over the cell array,
wherein, in the first wiring layer, a pattern between adjacent word lines, from among the plurality of word lines, is omitted.

10. The integrated circuit of any preceding claim, wherein each of the plurality of contacts has a top surface connected to the source or to the drain of the transistor of a corresponding one of the plurality of cells and a bottom surface connected to the power rail.
